**Europäisches Patentamt**

**European Patent Office**

**Office européen des brevets**

(19)

(11) Veröffentlichungsnummer: **0 058 443**
**B1**

(12) ## EUROPÄISCHE PATENTSCHRIFT

(45) Veröffentlichungstag der Patentschrift:
**10.07.85**

(51) Int. Cl.⁴: **H 03 F 3/217**

(21) Anmeldenummer: **82200083.2**

(22) Anmeldetag: **25.01.82**

(54) **Verfahren zum Verstärken eines analogen NF-Signals mit einem Schaltverstärker sowie Schaltverstärker zum Ausführen des Verfahrens.**

(30) Priorität: **16.02.81 CH 992/81**

(43) Veröffentlichungstag der Anmeldung:
**25.08.82 Patentblatt 82/34**

(45) Bekanntmachung des Hinweises auf die Patenterteilung:
**10.07.85 Patentblatt 85/28**

(84) Benannte Vertragsstaaten:
**CH DE FR GB LI**

(56) Entgegenhaltungen:
**DE - A - 1 953 755**
**US - A - 3 480 881**
**US - A - 4 153 882**

(73) Patentinhaber: **BBC Aktiengesellschaft Brown, Boveri & Cie., Haselstrasse, CH-5401 Baden (CH)**

(72) Erfinder: **Furrer, Andreas, Dipl.-Phys., Guggimoos 397, CH-5425 Schneisingen (CH)**
Erfinder: **Mertl, Vaclau, Dipl.-Ing., Kreuzbühlstrasse 27, CH-8600 Dübendorf (CH)**
Erfinder: **Milavec, Johann, Dipl.-Ing., Wiesenweg 5, CH-5200 Windisch (CH)**
Erfinder: **Stemmler, Herbert, Dr., Ahornweg 16, CH-5416 Kirchdorf (CH)**

## Beschreibung

Die vorliegende Erfindung betrifft ein Verfahren zum Verstärken eines analogen NF-Signals mit einem Schaltverstärker gemäß dem Oberbegriff des Anspruchs 1 sowie einen Schaltverstärker zum Ausführen des Verfahrens.

Das Verstärken analoger Signale mit einem Schaltverstärker kann trotz der erforderlichen Wandlung des analogen in ein impulsförmiges Steuersignal und der Rückwandlung des verstärkten impulsförmigen in ein analoges Ausgangssignal vorteilhaft sein, weil alle Verfahrensschritte mit modernen Festkörperbauelementen ausgeführt werden können, was im allgemeinen einen kompakteren Aufbau und eine längere Betriebsdauer des Verstärkers sowie eine wesentliche Verringerung der Verlustleistung ermöglicht.

Bei einigen der bisher bekannten Verfahren werden die Schaltelemente in den Schaltstufen mit Impulszügen angesteuert, deren Impulse eine konstante Folgefrequenz aufweisen und in Übereinstimmung mit dem gewandelten Analogsignal breitenmoduliert sind. Vorzugsweise werden zwei Impulszüge erzeugt, deren Impulse um 180° phasenverschoben sind.

Ein solcher Schaltverstärker ist beispielsweise in der GB-PS 1 248 209 (Plessey Co. Ltd.) beschrieben. Bei diesem Verstärker wird das amplitudenmodulierte analoge Eingangssignal in ein Impulsfolgenpaar mit breitenmodulierten, um 180° phasenverschobenen Impulsen gewandelt. Jede Impulsfolge steuert einen der zwei Schalttransistoren, die an den Enden der Primärwicklung eines Impulsübertragers angeschlossen sind. Der Mittelabgriff dieser Primärwicklung ist mit einer Speisespannungsquelle verbunden, so daß der Impulsübertrager im Gegentakt erregt wird. Die Sekundärwicklung des Übertragers ist über einen Brückengleichrichter mit einem Tiefpaßfilter verbunden, an dessen Ausgang eine Analogsignal erscheint, das dem verstärkten Eingangssignal entspricht.

Die Ausgangsleistung dieses Schaltverstärkers ist durch die von dem einen Impulsübertrager übertragbare Leistung begrenzt, und die Impulse werden beim Verstärken verformt, weshalb die Verwendungsmöglichkeiten dieses Schaltverstärkers beschränkt sind.

Es ist darum auch schon ein Schaltverstärker vorgeschlagen worden (CH-Patentgesuch 7 307/79), der zur Erhöhung der Schaltleistung eine Mehrzahl Schaltstufen enthält. Bei diesem Schaltverstärker wird das analoge Eingangssignal in mindestens ein Impulsfolgenpaar gewandelt, wobei die zwei um 180° phasenverschobenen Impulsfolgen aus breitenmodulierten Impulsen konstanter Folgefrequenz bestehen. Jede der Schaltstufen enthält zwei voneinander unabhängige Schaltkanäle, und jeder Schaltkanal enthält einen Impulsübertrager, dessen Primärwicklung mit einem Schaltelement verbunden ist. Die eine Impulsfolge des Impulsfolgenpaars ist zum Steuern der Schaltelemente in den einen Schaltkanälen der Schaltstufen und die andere Impulsfolge zum Steuern der Schaltelemente in den anderen Schaltkanälen vorgesehen. Die Sekundärwicklungen aller Impulsübertrager sind zum Aufsummieren der übertragenen Impulse in Serie geschaltet, wobei der eine Ausgang jeder Sekundärwicklung über einen Gleichrichter an die Serieleitung angeschlossen und in der Serieleitung zwischen den Anschlüssen der beiden Ausgänge jeder Sekundärwicklung ein weiterer Gleichrichter vorgesehen ist.

Bei einer praktisch erprobten Ausführungsform dieses Schaltverstärkers wurden mit jeder Impulsfolge die Schaltelemente in 48 Schaltstufen gesteuert. Die Speisespannung für die Primärwicklungen der Impulsübertrager betrug 500 Volt, das Übertragungsverhältnis 1 : 1,2, so daß an Ende der Serieschaltung der Sekundärwicklungen der Übertrager verstärkte Impulse mit einer Spitzenspannung von bis zu 28 kV erhalten wurden.

Die bei der genannten Spitzenspannung erforderliche Isolation zwischen der Sekundär- und der Primärwicklung der Impulsübertrager bildet eine unerwünschte Kapazität, die bei jedem Schalt- bzw. Übertragungsvorgang auf- und entladen wird. Das Umladen ist mit einer relativ großen Verlustleistung verbunden und kann bei hohen Schaltfrequenzen auch eine Verformung des übertragenen Impulses und damit eine Verzerrung des verstärkten Analogsignals bewirken.

Es ist weiterhin aus der DE-PS 1 953 755 ein Verfahren zur Leistungsverstärkung eines Analogsignals mit hohem Wirkungsgrad und geringem Verzerrungsgrad bekannt, bei dem auf den pulsdauermodulierten Betrieb der Schaltstufen verzichtet wird. Bei diesem bekannten Verfahren wird der Eingangssignalbereich in $2^n$ Amplitudenstufen unterteilt, das Eingangssignal periodisch abgetastet und jedem abgetasteten Amplitudenwert ein Wort von $n$ binären Zeichen zugeordnet, das jeweils die von dem Amplitudenwert erreichte Amplitudenstufe charakterisiert.

Den $n$ binären Zeichen jedes Wortes entsprechend werden $n$ unabhängige Schaltstufen angesteuert, wobei eine binäre »0« bzw. eine binäre »1« die zugeordnete Schaltstufe aus- bzw. einschaltet.

Eine solche binär codierte Verstärkung erfordert einerseits unterschiedliche Schaltstufen, die in ihrer Leistung entsprechend der Stellung des zugehörigen binären Zeichens in den Verhältnissen 1 : 2 : 4 : 8 : 16 … gewichtet sind. Andererseits führt die binäre Codierung dazu, daß z. B. beim Übergang vom binären Wort 01 111 zum binären Wort 10 000, der einer Veränderung des Eingangssignals von nur einem Aplitudenwert entspricht, die vier den niedrigsten vier Zeichen zugeordneten Schaltstufen aus-, die dem fünften Zeichen zugeordnete Schaltstufe dagegen eingeschaltet wird, so daß in insgesamt fünf Schaltstufen Schaltvorgänge stattfinden, obgleich die Eingangssignal-Änderung nur einen Amplitudenwert ausmacht.

Der vorliegenden Erfindung liegt darum die Aufgabe zugrunde, ein Verfahren zum Verstärken eines analogen NF-Signals zu schaffen, bei dem die Einschaltdauer der Schaltstufen in jeder Wandelperiode verlängert und dafür die Anzahl der einzuschaltenden Schaltstufen verringert wird.

Erfindungsgemäß wird diese Aufgabe bei einem Verfahren der eingangs genannten Art durch die Merkmale aus dem Kennzeichen des Anspruchs 1 gelöst.

Während bei den bisher gebräuchlichen Verfahren in jeder Wandelperiode alle Schaltstufen des Verstärkers mit breitenmodulierten Steuerimpulsen geschaltet wurden, ermöglicht das neue Verfahren nur eine durch den Momentanwert der Amplitude des Eingangssignals bestimmte Anzahl Schaltstufen während einer von der Sättigung des Übertragers bestimmten optimalen zeitlichen Dauer einzuschalten. Damit kann die Anzahl der Schaltvorgänge in jeder Wandelperiode ganz wesentlich verringert werden und damit auch die durch die Schaltvorgänge bewirkten Verluste und die Verformungen des übertragenen Impulses.

Bei einer bevorzugten Ausführungsform des neuen Verfahrens wird jeder Spannungsbereich in eine vorgegebene Anzahl Teilbereiche unterteilt und beim Messen eines Momentanwerts, der zwischen zwei Summen der Spannungsbereiche liegt, so daß nach dem Bestimmen der Summe ein Amplitudenrest verbleibt, eine weitere Schaltstufe pulsdauermoduliert, d. h. mit zeitlicher Verzögerung ein- oder vorzeitig ausgeschaltet wird, wobei das Verhältnis der Dauer der Einschaltzeit zum zeitlichen Abstand zwischen aufeinanderfolgenden Messungen des Momentanwerts proportional zum Verhältnis des Amplitudenrestwerts zu einem Spannungsbereich ist.

Diese Ausführungsform des Verfahrens ermöglicht durch die Kombination der neuen Modulation der Anzahl der während einer optimalen Zeitspanne eingeschalteten Schaltstufen mit der zusätzlichen Pulsdauermodulation mindestens einer Schaltstufe eine noch verzerrungsfreiere Verstärkung des analogen Signals.

Nachfolgend wird das neue Verfahren mit Hilfe der Figuren an einer Prinzipschaltung und am Blockschaltbild eines erprobten Schaltverstärkers erläutert. Es zeigt

Fig. 1 das Prinzipschema eines Schaltverstärkers,

Fig. 2 eine Periode eines analogen Eingangssignals und das entsprechende, an der Serieleitung der Schaltstufenausgänge erscheinende, aus impulsförmigen Signalen zusammengesetzte Signal,

Fig. 3 das Blockschema einer erprobten Ausführungsform eines NF-Leistungsverstärkers, und

Fig. 4 eine Periode eines analogen Eingangssignals, das an der Serieleitung der Verstärkerkanalausgänge erscheinende, aus Schaltimpulsen zusammengesetzte und das am Ausgang des Filters erscheinende analoge Ausgangssignal.

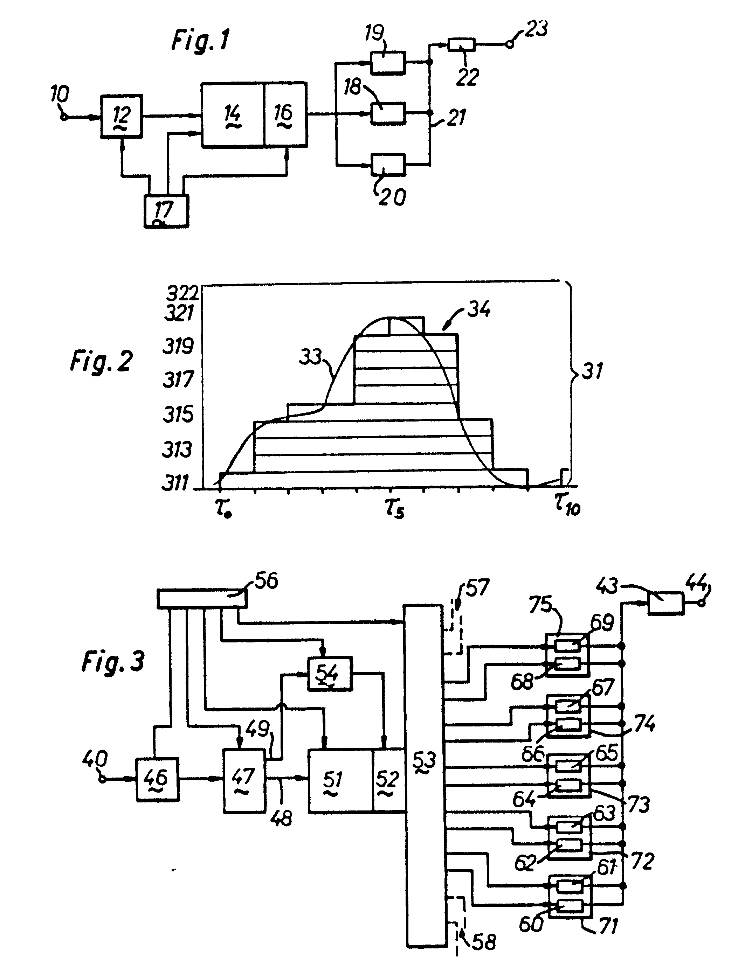

Der in Fig. 1 im Prinzipschema gezeigte Schaltverstärker enthält einen A/D-Wandler 12, dessen Eingang mit der Eingangsklemme 10 des Schaltverstärkers und dessen Ausgang mit dem Eingang eines Speichers 14 verbunden ist. Am Ausgang des Speichers ist eine steuerbare Ausspeicherschaltung 16 vorgesehen. Weiter enthält der Schaltverstärker einen Taktgeber 17, der im A/D-Wandler den Zeitpunkt der Wandlung des an der Eingangsklemme liegenden Analogsignals in ein Digitalsignal, im Speicher den Zeitpunkt des Einspeicherns dieses Digitalsignals und in der Ausspeicherschaltung den Zeitpunkt des Ausspeicherns der gespeicherten Digitalsignale bestimmt. Die Ausspeicherschaltung weist mehrere Ausgänge auf, von denen jeder mit dem Schaltelement in einer von mehreren Schaltstufen verbunden ist, von denen in Fig. 1 nur die drei Schaltstufen 18, 19 und 20 gezeigt sind. Die Ausgänge der Schaltstufen sind zu einer Serieleitung 21 verbunden, deren Ende an den Eingang eines Tiefpaßfilters 22 geführt ist. Der Ausgang des Tiefpaßfilters ist an die Ausgangsklemme 23 des Leistungsverstärkers angeschlossen.

Damit jede Schaltstufe mit einem zugeordneten Steuersignal gesteuert werden kann, muß die Anzahl der vom A/D-Wandler erzeugbaren Digitalsignal mindestens so groß wie die Anzahl der Schaltstufen sein. Fig. 2 zeigt den Bereich 31 des maximal wandelbaren Analogsignals, der in zwölf Spannungsbereiche 311 bis 322 unterteilt ist. Jedem Spannungsbereich ist ein Digitalsignal, z. B. eine der Ziffern 1 bis 12, zugeordnet.

Zur Beschreibung der Arbeitsweise des in Fig. 1 gezeigten Schaltverstärkers sei angenommen, daß das in Fig. 2 gezeigte Analogsignal 33 an die Eingangsklemme 10 des Verstärkers und damit auch an den Eingang des A/D-Wandlers 12 geleitet wird. Der vom Taktgeber 17 gesteuerte Wandler tastet zu den Zeitpunkten $\tau_0$ bis $\tau_{10}$ die Amplitude des Analogsignals ab und erzeugt ein digitales Ausgangssignal, das mit der dem abgetasteten Momentanwert der Amplitude entsprechenden Anzahl Spannungsbereichen übereinstimmt. Im gezeigten Beispiel sind das zu den Zeitpunkten $\tau_0$ bis $\tau_{10}$ die digitalen Ausgangssignale 1, 4, 5, 5, 9, 10, 9, 4, 1, 0 und 1. Diese Ausgangssignale werden nacheinander in den Speicher 14 eingespeichert. Wiederum vom Taktgeber 17 gesteuert liest die Ausspeicherschaltung 16 den Speicher aus und leitet den Inhalt der einzelnen Speicherzellen als Steuersignale für die Schaltelemente der Schaltstufen auf die zugeordneten Signalleitungen. Die Ausgangssignale der Schaltstufen werden in der Serieleitung zu dem in Fig. 2 gezeigten treppenförmigen Signal 34 überlagert und in dem Tiefpaßfilter 22 zu einem verstärkten Analogsignal zurückverformt, dessen zeitlicher Verlauf dem Analogsignal an der Eingangsklemme des Verstärkers weitgehend entspricht.

Dabei versteht sich, daß die Übereinstimmung zwischen dem Analogsignal 33 und der Hüllkurve des aus den treppenförmig überlagerten Ausgangssignalen der Schaltstufen zusammengesetzten Signals 34 um so besser ist, je kürzer die zeitlichen Abstände zwischen aufeinanderfolgenden Abtastungen des Analogsignals sind und je größer die Anzahl der Spannungsbereiche im maximal wandelbaren Analogbereich ist. Praktisch sind diesen beiden Forderungen Grenzen gesetzt, weil die Einstellzeit des zum Abtasten des Analogwerts verwendeten A/D-Wandlers nicht beliebig klein gemacht werden kann und der Aufwand zum Verstärken der den einzelnen Spannungsbereichen entsprechenden Signale auf ein sinnvolles Maß zu begrenzen ist.

Die Fig. 3 zeigt das Blockschema einer erprobten Ausführungsform eines Schaltverstärkers. Beim Aufbau dieses Leistungsverstärkers war davon auszugehen, daß zum Erreichen der angestrebten Verstärkung 48 nebeneinander angeordnete Schaltstufen erforderlich sind. Für die unabhängige Ansteuerung dieser Schaltstufen sind 48 Steuersignalfolgen erforderlich, was gemäß den obigen Ausführungen zu den Fig. 1 und 2 eine Unterteilung des maximal wandelbaren Analogsignals in 48 Spannungsbereiche erfordert. Um die Genauigkeit bei der Bestimmung des abgetasteten Amplitudenwerts zu erhöhen, wurde ein A/D-Wandler 46 verwendet, der ein 10-Bit-Ausgangssignal abgibt, was einer Unterteilung des maximal wandelbaren Analogwerts in 1024 Digitalwerte entspricht. Weil der Schaltverstärker nur 48 Steuersignalfolgen verarbeiten kann, ist dem A/D-Wandler eine Teilerschaltung 47 nachgesetzt, die das digitale Ausgangssignal des Wandlers durch fortgesetzte Subtraktion des Quotienten (1024 : 48) solange vermindert, bis das digitale Ausgangssignal Null ist oder einem nicht weiter teilbaren Rest entspricht. Die Teilerschaltung enthält zwei Ausgänge. Am einen Ausgang 48 erscheinen die Ordnungszahlen der nacheinander ausgeführten Subtraktionen, am anderen Ausgang 49 erscheint der nach der letzten Subtraktion gegebenenfalls verbliebene Rest. Die Ordnungszahlen der ausgeführten Subtraktionen werden an einen Speicher 51 geleitet, dessen Speicherplätze mit diesen Ordnungszahlen adressierbar sind und worin nach Beendigung aller Subtraktionen jeder adressierte Speicherplatz gesetzt und jeder nicht adressierte Speicherplatz zurückgesetzt wird.

Der Speicherausgang ist über eine Ausspeicherschaltung 52 mit einem Steuerimpulsgenerator 53 verbunden. Der Steuerimpulsgenerator enthält eine Mehrzahl Schaltglieder, von denen jedes einem Speicherplatz zugeordnet ist und beim Erscheinen eines Schalttaktes den Inhalt des zugeordneten Speicherplatzes als Steuerimpuls auf die Steuerleitung für den nachgeschalteten Verstärkerkanal gibt. In Fig. 3 sind nur die Steuerleitungen für fünf Schaltstufen 71 bis 75, von denen jede zwei Schaltkanäle 60, 61; ..., 68, 69 enthält, gezeigt. Weitere Steuerleitungen sind mit den gestrichelten Linien 57, 58 angedeutet.

Der Ausgang 49 der Teilerschaltung 47 ist mit einem Rechenwerk 54 verbunden, das eine Steuersignaldauer errechnet, deren Verhältnis zur Zeispanne zwischen aufeinanderfolgenden Taktimpulsen der Differenz zwischen dem Subtraktionsrest und dem Substrahenten, d. h. dem Quotienten (1024 : 48) entspricht. Dieses dauermodulierte Steuersignal wird an die Ausspeicherschaltung 52 geleitet, die für jeden Speicherplatz im Speicher 51 einen zugeordneten Verzögerungskreis enthält, und steuert denjenigen Verzögerungskreis, der dem gesetzten Speicherplatz mit der höchsten Ordnungszahl zugeordnet ist. Mit der verzögerten Weiterleitung des Inhalts des »letzten« gesetzten Speicherplatzes wird eine Breitenmodulation des Steuerimpulses für einen Schaltkanal bewirkt, welche Breitenmodulation ermöglicht, die Hüllkurve der treppenartig überlagerten Ausgangssignale der Schaltkanäle besser an das Analogsignal anzupassen.

Bei der beschriebenen Ausführungsform erzeugt der Taktgeber 56 zwei Taktfolgen. Die eine Taktfolge mit einer Frequenz von 80 kHz wird an den A/D-Wandler 46 und an die Speicherschaltung 51 geleitet, die andere Taktfolge mit einer Frequenz von 100 MHz steuert die Teilerschaltung 47 und das Rechenwerk 54. Damit ist es möglich, die Amplitude des Analogsignals in zeitlichen Abständen von 12,5 µs abzutasten und in gleichen Abständen die Steuerimpulse für die Schaltkanäle auszugeben. Zum Kompensieren der Rechen- und Einspeicherzeit werden die Steuerimpulse, die einer bei einem gegebenen Zeittakt erfolgten Abtastung des Analogsignals entsprechen, erst beim nachfolgenden Zeittakt vom Steuerimpulsgenerator freigegeben.

Wie in dem bereits erwähnten CH-Patentgesuch 7 307/79 ausführlich beschrieben ist, enthält jeder Schaltkanal einen Impulsübertrager, der wegen der unvermeidlichen Sättigung nur Impulse bis zu etwa 50 µs Dauer übertragen kann. Zum Übertragen von Impulsen längerer Dauer sind darum in dem vorgeschlagenen Schaltverstärker je zwei Schaltkanäle 60, 61; 62, 63; 64, 65; 66, 67 und 68, 69 zu einer Schaltstufe 71, 72, 73, 74 bzw. 75 zusammengeschaltet. Der Steuerimpulsgenerator 53 bewirkt nun, daß Steuerimpulse, deren Dauer länger ist als 50 µs, alternierend an den einen und den anderen Schaltkanal der zugeordneten Schaltstufe geleitet werden. Weiter bewirkt der Impulsgenerator 53, daß die an die einzelnen Schaltstufen 71–75 geleiteten Steuerimpulse um einen Zeittakt von 12,5 µs gegeneinander verschoben sind. Damit wird erreicht, daß die Schaltkanäle in den angesteuerten Schaltstufen nicht gleichzeitig umgeschaltet werden.

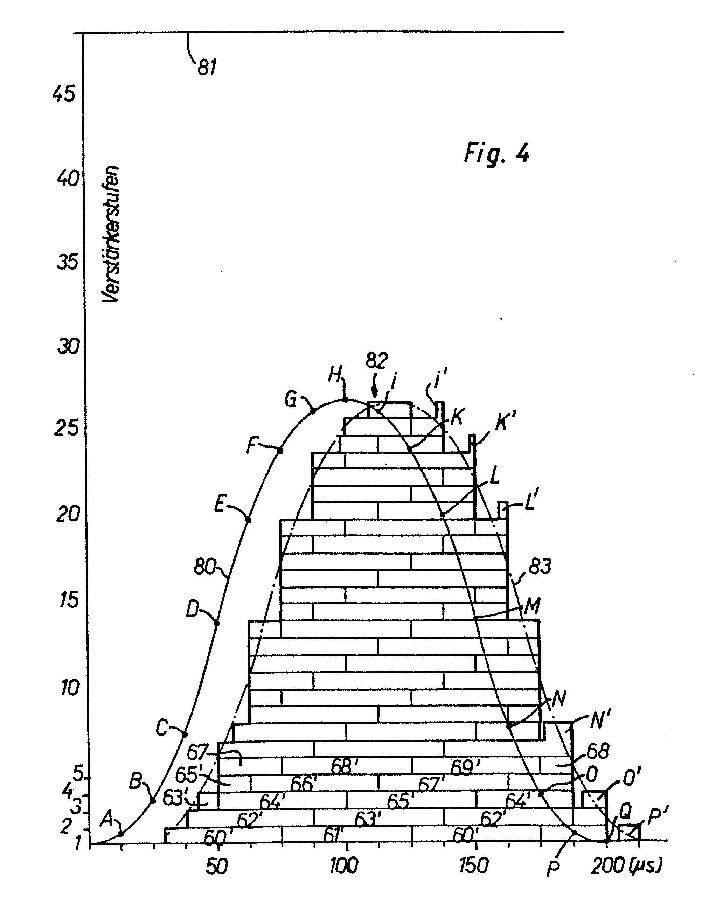

In Fig. 4 ist die Bildung eines Analogsignals mit Hilfe der von den Schaltkanälen eines Schaltverstärkers gemäß der Fig. 3 erzeugten Schaltimpulsen gezeigt. Dazu sei angenommen, daß das einfacherweise sinusförmige analoge Eingangssignal 80 mit einer zeitlichen Dauer von 200 µs, entsprechend einer Frequenz von 5 kHz, im A/D-Wandler 46 alle 12,5 µs, entsprechend einer Frequenz von 80 kHz, abgetastet wird und der abgetastete Analogwert als Digitalwert am Ausgang des Wandlers erscheint. Wie bereits weiter oben beschrieben wurde, ermöglicht der A/D-Wandler, den maximal wandelbaren Analogbereich 81 in 1024 Digitalwerte zu unterteilen, während die Schaltstufen nur 48 Steuerimpulse verarbeiten können. Der am Ausgang des A/D-Wandlers erscheinende Digitalwert wird darum in der nachfolgenden Teilerschaltung 47 in Digitalwertstufen, von denen jede 20 Digitalwerte enthält, unterteilt. In Fig. 4 sind auf der Ordinate nur die Digitalwertstufen aufgetragen.

Zum besseren Verständnis der nachfolgenden Beschreibung sei nochmals darauf hingewiesen, daß der Speicher 51 derart aufgebaut ist, daß bei jedem Taktsignal alle nicht gesetzten Speicherplätze zurückgesetzt werden.

Weiter sei angenommen, daß beim ersten Zeittakt zum Zeitpunkt Null alle Speicherplätze zurückgesetzt sind, d. h. kein ausspeicherbares Signal vorhanden ist. Zu diesem Zeitpunkt ist auch die Amplitude des Ananlogsignals Null, weshalb nach dem Abtasten des Signals am Ausgang des A/D-Wandlers das Digitalsignal Null erscheint, das nicht weiter verarbeitet wird.

Beim zweiten Zeittakt zum Zeitpunkt 12,5 μs sind immer noch alle Speicherplätze zurückgesetzt, und es kann kein Signal ausgespeichert werden. Dafür wird beim Abtasten des Analogsignals ein Analogwert A festgestellt, der etwa 18 Digitalwerten entspricht. Am Ausgang der Teilerschaltung 47 erscheint dann auf der Leitung 48 eine »1« und auf der Leitung 49 eine »18«, was bedeutet, daß schon bei der ersten Subtraktion von (1024 : 48) Digitalwerten ein Rest von 18 verblieben ist. Folglich wird im Speicher 51 ein Speicherplatz gesetzt, und das Rechenwerk 54 liefert an die Ausspeicherschaltung 52 ein Verzögerungssignal, das das Ausspeichern des Speicherinhalts mit einer Verzögerung von etwa $^2/_{20}$ der Taktzeit, im vorliegenden Beispiel also 1,25 μs, bewirkt.

Beim dritten Zeittakt zum Zeitpunkt 25 μs wird der Inhalt des Speichers mit der genannten Verzögerung ausgelesen und als impulsförmiges Steuersignal auf eine Steuerleitung für einen der Schaltkanäle gegeben. Zugleich wird das Analogsignal abgetastet und dabei der Analogwert B festgestellt, der etwa 50 Digitalwerten entspricht. Am Ausgang der Teilerschaltung 47 erscheint dann auf der Leitung 48 eine »3« und auf der Leitung 49 eine »10«, was bedeutet, daß bei dreimaliger Subtraktion (1024 : 48) Digitalwerten ein Rest von 10 verblieben ist. Dann werden drei Speicherplätze im Speicher 51 gesetzt, und das Rechenwerk 54 liefert an die Ausspeicherschaltung 52 ein Verzögerungssignal, das beim Ausspeichern des Speicherinhalts den Inhalt des dritten Speicherplatzes um etwa $^{10}/_{20}$ Taktzeit, d. h. im 6,25 μs, verzögert.

Beim vierten Zeittakt zum Zeitpunkt 37,5 μs wird der Inhalt des Speichers ausgelesen und auf jede Steuerleitung, die einem gesetzten Speicherplatz zugeordnet ist, ein Steuersignal gegeben, wobei das dem Speicherplatz 3 entsprechende Steuersignal, wie oben beschrieben, verzögert ist. Zugleich wird das Analogsignal abgetastet und der Analogwert C in etwa 130 Digitalwerte gewandelt. Diese Digitalwerte werden auf die gleiche Weise wie bereits oben beschrieben in 7 Digitalwertstufen geteilt, die im Speicher sieben Speicherplätze setzen, wovon der siebte mit einer Verzögerung von $^{10}/_{20}$ Taktzeit oder 6,25 μs ausgespeichert wird.

Das Analogsignal wird dann bei jedem der folgenden Zeittakte 5 bis 17 weiter abgetastet, und die ermittelten Analogwerte D bis Q werden in der beschriebenen Weise gewandelt, in den Speicher 51 eingespeichert und beim jeweils nachfolgenden Zeittakt 6 bis 18 aus dem Speicher ausgespeichert und als Steuerimpulse auf die zugeordneten Steuersignalleitungen gegeben.

Der beim zehnten Zeittakt ermittelte Analogwert I entspricht etwa 510 Digitalwerten. Auf der Ausgangsleitung 48 der Teilerschaltung 47 erscheint darun eine »26« und auf der Ausgangsleitung 49 eine »10«. Folglich werden beim nachfolgenden zwölften Zeittakt im Speicher 51 nur 26 Speicherplätze gesetzt, und vom Rechenwerk 54 wird für den sechsundzwanzigsten Speicherplatz ein Verzögerungssignal errechnet, das etwa einer halben Taktzeit entspricht und den verzögerten Steuerimpuls I' bewirkt. Entsprechendes gilt für die Steuerimpuls K', L', N', O' und P'.

Wie bereits weiter oben beschrieben wurde, werden zum Kompensieren der Rechen- und Einspeicherzeit die Steuerimpulse, die einer bei einem gegebenen Zeittakt erfolgten Abtastung des Analogsignals entsprechen, erst beim nachfolgenden Zeittakt vom Steuerimpulsgenerator freigegeben. Das hat zur Folge, daß das aus Impulsen zusammengesetzte Signal 82 auf der die Ausgänge der Schaltkanäle verbindenden Serieleitung und das Ausgangssignal 83 des Schaltverstärkers um die Dauer eines Zeittaktes bzw. um etwa eineinhalb Zeittakte, gegenüber dem Eingangssignal des Verstärkers verschoben sind.

Wie bereits weiter oben beschrieben wurde, ist die Einschaltzeit für die Impulsübertrager in den Schaltkanälen begrenzt, weshalb die Kanäle paarweise zu Schaltstufen zusammengefaßt sind. Dementsprechend ist der Steuerimpulsgenerator 53 so angelegt, daß der Inhalt einer Speicherzelle alternierend auf die beiden Steuersignalleitungen der zugeordneten Schaltstufe gegeben wird. Dabei erfolgt das Umschalten zwischen den Signalleitungen für die Schaltkanäle in den verschiedenen Schaltstufen nicht gleichzeitig, sondern taktverschoben, wie es in Fig. 4 für die fünf Schaltstufen 71 bis 75 und die entsprechenden Einschaltperioden 60', 61'; 62', 63'; 64', 65'; 66', 67' und 68', 69' gezeigt ist. Damit wird erreicht, daß nur ein Viertel der angesteuerten Schaltkanäle zum gleichen Zeitpunkt umgeschaltet werden.

Wie aus Fig. 4 zu ersehen ist, wird bei dem neuen Verfahren das Analogsignal nicht in eine vom Momentanwert der Amplitude unabhängige, maximal verarbeitbare Anzahl breitenmodulierter Impulse gewandelt, sondern in eine dem Momentanwert des Analogsignals proportionale Anzahl Impulse mit maximaler Breite. Auf diese Weise ist es möglich, ein Analogsignal mit einer Mindestanzahl impulsförmiger Signale darzustellen bzw. in einem Schaltverstärker mit einer Mindestanzahl Schaltvorgängen zu verstärken. Daß dadurch die Schaltverluste im Schaltverstärker ganz wesentlich vermindert werden können, wurde bereits einleitend erwähnt.

Es versteht sich, daß das neue Verfahren und der beschriebene Schaltverstärker auf vielerlei Weise abgewandelt und an bestimmte Arbeitsbedingungen angepaßt werden kann. Beispielsweise ist es möglich, anstelle der beschriebenen breiten Steuerimpulse auch sehr kurze Steuerimpulse zu verwenden, mit einem der Vorderkante des breiten Steuerimpulses entsprechenden Einschaltimpuls und einem der rückwärtigen Kante entsprechenden Ausschaltimpuls. Weiter ist es nicht erforderlich, jeder Schaltstufe eine Steuerleitung oder -leitungen zuzuordnen. Statt dessen können die Ein- und Ausschaltimpulse mit Adressen versehen und im Zeitmultiplexverfahren auf einer einzigen Steuerleitung an alle zugeordneten Schaltstufen bzw. -kanäle geleitet werden. Es ist auch nicht notwendig, daß die angesteuerten Schaltstufen den zeitlichen Verlauf des Analogsignals simulieren, wie es zur einfacheren Erklärung der Arbeitsweise in Fig. 4 gezeigt ist. Weil die Ausgangssignale der Schaltstufen auf der Serieleitung addiert werden, ist das an der Ausgangsklemme 44 erscheinende verstärkte Analogsignal immer das gleiche, unabhängig davon, welche Schaltstufe von welchem Steuersignal eingeschaltet wurde und auch unabhängig davon, ob eine Schaltstufe vom gleichen Steuersignal ein- und ausgeschaltet wird.

Die beschriebene Vorrichtung zur Ausführung des neuen Verfahrens kann mit handelsüblichen, jedem Fachmann bekannten Bauelementen realisiert werden, weshalb auf deren Beschreibung hier ausdrücklich verzichtet wird.

**Patentansprüche**

1. Verfahren zum Verstärken eines analogen NF-Signals mittels eines Schaltverstärkers, welcher Schaltverstärker mehrere unabhängig voneinander ansteuerbare Schaltstufen (18, 19, 20; 71, . . ., 75) enthält, deren Ausgänge mit einem Tiefpaßfilter (22, 43) verbunden sind, bei welchem Verfahren die zulässige Eingangsspannung des Schaltverstärkers in mehrere gleich große Spannungsbereiche (311, . . ., 322) unterteilt, in vorgegebenen zeitlichen Abständen der Momentanwert der Amplitude des NF-Signals gemessen und die Anzahl der Spannungsbereiche (311, . . ., 322) bestimmt wird, deren Summe gleich oder um weniger als einen Spannungsbereich (311, . . ., 322) kleiner als dieser Momentanwert ist, dadurch gekennzeichnet, daß

— jedem Spannungsbereich (311, . . ., 322) wenigstens eine Schaltstufe (18, 19, 20; 71, . . ., 75) zugeordnet wird,
— die aus der Messung des Momentanwerts bestimmte Summe mit der bei der vorangegangenen Messung des Momentanwerts auf die gleiche Weise bestimmten Summe verglichen und die Differenz beider Summen gebildet wird, und
— eine dem Zahlenwert der Differenz entsprechende Anzahl der Schaltstufen (18, 19, 20; 71, . . ., 75) zugeschaltet wird, wenn die Differenz positiv ist, und
— eine dem Zahlenwert der Differenz entsprechende Anzahl der Schaltstufen (18, 19, 20; 71, . . ., 75) abgeschaltet wird, wenn die Differenz negativ ist.

2. Verfahren nach Anspruch 1, dadurch gekennzeichnet, daß jeder Spannungsbereich (311, . . ., 322) in eine vorgegebene Anzahl Teilbereiche unterteilt wird, und dadurch, daß beim Messen eines Momentanwerts, der zwischen zwei Summen der Spannungsbereiche (311, . . ., 322) liegt, so daß nach dem Bestimmen der Summe ein Amplitudenrestwert verbleibt, eine weitere Schaltstufe pulsdauermoduliert wird, wobei das Verhältnis der Dauer des dauermodulierten Impulses zum zeitlichen Abstand zwischen aufeinanderfolgenden Messungen des Momentanwerts proportional zum Verhältnis des Amplitudenrestwerts zu einem Spannungsbereich (311, . . ., 322) ist.

3. Verfahren nach Anspruch 1, dadurch gekennzeichnet, daß Schaltstufen (18, 19, 20; 71, . . ., 75) mit je zwei parallel liegenden, beim Zuschalten einer Schaltstufe (18, 19, 20; 71, . . ., 75) alternierend eingeschalteten Schaltkanälen (60, . . ., 69) verwendet werden, und die Zeitpunkte für das alternierende Ein- und Ausschalten der Schaltkanäle (60, . . ., 69) in den zugeschalteten Schaltstufen gegeneinander geschoben sind, welche Verschiebung ein Viertel des Zeitabstandes für das alternierende Ein- und Ausschalten beträgt.

4. Schaltverstärker zum Ausführen des Verfahrens gemäß Anspruch 1, gekennzeichnet durch einen A/D-Wandler (46), der in vorgegebenen zeitlichen Abständen dem Momentanwert der Amplitude des NF-Signals entsprechende digitale Signale erzeugt, einen Speicher (51), dessen Speicherplätze von den digitalen Signalen adressierbar und setzbar sind, sowie einen Steuerimpulsgenerator (53), der in Übereinstimmung mit den gesetzten Speicherplätzen Steuerimpulse für die Schaltelemente in den Schaltstufen (18, 19, 20) bzw. den Schaltkanälen (60, 61; 62, 63; . . . 69) erzeugt.

5. Schaltverstärker nach Anspruch 4, gekennzeichnet durch eine Teilerschaltung (47), die dem A/D-Wandler (46) nachgeschaltet ist und die an dessen Ausgang erscheinenden Digitalwerte in Digitalwertegruppen und gegebenenfalls einen Digitalwerterest teilt, die als Adreßsignale und zum Setzen von Speicherplätzen an den Speicher (51) geleitet werden, und durch ein Rechenwerk (54), das einen Digitalwerterest in ein dauermoduliertes Ausspeichersignal umwandelt, sowie durch eine Ausspeicherschaltung (52), die in vorgegebenen zeitlichen Abständen die Anzahl der gesetzten Speicherplätze, wovon gegebenenfalls einer dem Amplitudenrestwert zugeordnet ist, als Erregersignale an den Steuerimpulsgenerator (53) weiterleitet.

## Claims

1. Method for amplifying an analogue LF signal by means of a switching amplifier, which switching amplifier contains several switching stages (18, 19, 20; 71, ... 75) which can be activated independently of each other and the outputs of which are connected to a low-pass filter (22, 43), in which method the permissible input voltage of the switching amplifier is subdivided into several equally large voltage ranges (311, ..., 322), the instantaneous value of the amplitude of the LF signal is measured at predetermined time intervals and the number of the voltage ranges (311, ..., 322) is determined the sum of which is equal to or by less than one voltage range (311, ..., 322) smaller than this instantaneous value, characterized in that

— each voltage range (311, ..., 322) is associated with at least one switching stage (18, 19, 20; 71, ..., 75)
— the sum determined from the measurement of the instanteneous value is compared with the sum determined in the same manner during the preceding measurement of the instantaneous value and the difference between both sums is formed, and
— a number, corresponding to the numerical value of the difference, of the switching stages (18, 19, 20; 71, ..., 75) is connected into circuit if the difference is positive, and
— a number, corresponding to the numerical value of the difference, of the switching stages (18, 19, 20; 71, ..., 75) is switched out of circuit if the difference is negative.

2. Method according to claim 1, characterized in that each voltage range (311, ..., 322) is subdivided into a predetermined number of part ranges, and that if an instantaneous value is measured which lies between two sums of the voltage ranges (311, ..., 322) so that a residual amplitude value remains after determination of the sum, a further switching stage is pulse-duration modulated, the ratio between the duration of the duration-modulated pulse and the time interval between successive measurements of the instantaneous value being proportional to the ratio between the residual amplitude value and one voltage range (311, ..., 322).

3. Method according to claim 1, characterized in that switching stages (18, 19, 20; 71, ..., 75) are used which comprise two parallel switching channels (60, ..., 69) each which are alternately switched on when a switching stage (18, 19, 20; 71, ..., 75) is switched into circuit, and the times for the alternating switching-on and switching-off of the switching channels (60, ..., 69) in the switching stages connected into circuit are displaced with respect to each other, which displacement amounts to one quarter of the time interval for the alternating switching-on and switching-off.

4. Switching amplifier for carrying out the method according to claim 1, characterized by an A/D converter (46) which generates at predetermined time intervals digital signals corresponding to the instantaneous value of the amplitude of the LF signal, a memory (51) the memory locations of which are adressable by digital signals an setable, and a control pulse generator (53) which, in agreement with the memory locations set, generates control pulses for the switching elements in den switching stages (18, 19, 20) or the switching channels (60, 61; 62, 63; ... 69).

5. Switching amplifier according to claim 4, characterized by a divider circuit (47) which follows the A/D converter (46) and divides the digital values appearing at the output of the latter into groups of digital values and, if necessary, a digital value remainder which are fed to the memory (51) as address signals and for setting memory locations, and by an arithmetic unit (54) which converts a digital value remainder into a duration-modulated transfer signal, and by a transfer circuit (52) which transfers at predetermined time intervals the number of memory locations set, one of which, if necessary, is associated with the amplitude remainder value, as exciter signals to the control pulse generator (53).

## Revendications

1. Procédé pour amplifier un signal analogique à basse fréquence au moyen d'un amplificateur à commutation, cet amplificateur à commutation comprenant plusieurs étages de commutation (18, 19, 20; 71, ..., 75) qui peuvent être activés indépendamment les uns des autres et dont les sorties sont connectées à un filtre passe-bas (22, 43), selon lequel la tension d'entrée admissible de l'amplificateur à commutation est subdivisée en plusieurs domaines de tensions d'égale importance (311, ..., 322), la valeur du moment de l'amplitude du signal à basse fréquence est mesurée à des intevalles préétablis et le nombre des domaines de tensions (311, ..., 322) dont les sommes sont égales à cette valeur du moment ou inférieures d'un domaine de tensions (311, ..., 322) à cette valeur du moment est déterminé, caractérisé en ce que:

— au moins un étage de commutation (18, 19, 20; 71, ..., 75) est associé à chaque domaine de tensions (311, ..., 322),

— la somme déterminée à partir de la mesure de la valeur du moment est comparée à la somme déterminée de la même manière lors de la mesure précédente de la valeur du moment et la différence des deux sommes est formée, et

— un nombre des étages de commutation (18, 19, 20; 71, . . ., 75) correspondant à la valeur numérique de la différence est enclenché lorsque la différence est positive, et

— un nombre d'étages de commutation (18, 19, 20; 71, . . ., 75) correspondant à la valeur numérique de la différence est déclenché lorsque la différence est négative

2. Procédé suivant la revendication 1, caractérisé en ce que chaque domaine de tensions (311, . . ., 322) est subdividée en un nombre préétabli de domaines partiels et en conséquence du fait que lors de la mesure d'une valeur du moment qui se situe entre deux sommes des domaines de tensions (311, . . ., 322), une valeur de reste d'amplitude subsiste après la détermination de la somme, un autre étage de commutation subit une mobulation d'impulsions en durée, de sorte que le rapport de la durée de l'impulsion modulée en durée à l'intervalle de temps entre des mesures successives de la valeur du moment est proportionnel au rapport de la valeur de reste d'amplitude à un domaine de tensions (311, . . ., 322).

3. Procédé suivant la revendication 1, caractérisé en ce qu'on utilise des étages de commutation (18, 19, 20; 71, . . ., 75) comportant chacun deux canaux de commutation (60, . . ., 69) disposés en parallèle enclenches en alternace lors de la connexion d'un étage de commutation (18, 19, 20; 71, . . ., 75), les moments pour l'enclenchement et le déclenchement alternés des canaux de commutation (60, . . ., 69) étant décalés l'un par rapport à l'autre dans les étages de commutation connectés, le décalage étant égal au quart de l'intervalle de temps pour l'enclenchement et le déclenchement alternés.

4. Amplificateur à commutation pour l'exécution du procédé suivant la revendication 1, caractérisé par un convertisseur analogique-numérique (46) qui, à des intervalles de temps préétablis, produit des signaux numériques correspondant à la valeur du moment de l'amplitude du signal à basse fréquence, une mémoire (51) dont les emplacements de stockage peuvent être adressés et positionnés par les signaux numériques ainsi qu'un générateur d'impulsions de commande (53) qui produit, en coïncidence avec les emplacements de stockage positionnés, des impulsions de commande pour les éléments de commutation dans les étages de commutation (18, 19, 20) ou les canaux de commutation (60, 61; 62, 63; . , 69).

5. Amplificateur à commutation suivant la revendication 4, caractérisé par un circuit diviseur (47) qui suit le convertisseur analogique-numérique (46) et qui divise les valeurs numriques apparaissant à sa sortie en des groupes de valeurs numériques avec, le cas échéant, un reste de valeur numérique qui sont amenés à titre de signaux d'adresses et pour le positionnement des emplacements de stockage à la mémoire (51), et par un bloc de calcul (54) qui convertit un reste de valeur numérique en un signal de vidage modulé en durée, ainsi que par un circuit de vidage (52) qui, à des intervalles de temps préétablis, transfère le nombre d'emplacements de stockage positionnés dont l'un est associé, le cas échéant, à la valeur de reste d'amplitude, en tant que signaux d'axcitation, au générateur d'impulsions de commande (53).

**Fig.1**

**Fig.2**

**Fig.3**

Fig. 4